# EUROPEAN PATENT APPLICATION

(11) **EP 3 179 625 A1**
(43) Date of publication of application: **14.06.2017**
(21) Application number: 15198222.0
(22) Date of filing: 07.12.2015
(51) Int. Cl.: H02P 29/02, G05B 9/02

(54) **A METHOD AND APPARATUS FOR TESTING SAFE TORQUE OFF CIRCUITRY IN ELECTRIC DRIVES**

(71) Applicant: ABB Technology Oy, 00380 Helsinki (FI)
(72) Inventor: SÄRKIMÄKI, Ville, 00381 Helsinki (FI); ISAKSSON, Petri, 00381 Helsinki (FI); ALKKIOMÄKI, Olli, 00381 Helsinki (FI); LEHTONEN, Teemu, 00381 Helsinki (FI); HEIKKILÄ, Joni, 00381 Helsinki (FI)
(74) Representative: Seppo Laine Oy

(57) **Abstract**

A method and apparatus for testing the function of a Safe Torque Off (STO) feature (100) for an electric drive. After activation of the STO feature (110), predefined switching commands are transmitted (122) to power switches of the electric drive (130). Then a switching state of the power switches is determined responsive to the predefined switching commands. Finally, the functionality of the STO feature is determined based at least upon the determined switching states.

## Description

### FIELD

Safe torque off (STO) is a standard safety feature on many electric drives. STO functions by removing the load from the electric drive through the opening of the electronic switches of the drive. As a safety feature it is desired that the function of STO be monitored. This monitoring is desirably not only during production but also on an ongoing and regular basis, especially after maintenance.

### BACKGROUND

As a general concept, drives regulate the control of electric energy to a motor or load. Electric energy is supplied to the drive, often in the form of Alternating Current (AC) from a local distribution system. This AC supply is then rectified to Direct Current (DC) supply within the drive. The drive can then take this DC supply and invert it back to an AC output at a desired frequency and voltage. This frequency and voltage is matched to the demands of the motor or load connected to the drive. As such a drive is a device which regulates the supply of energy by controlling at least one of a voltage and frequency of an AC output. Drives use many methods to accomplish the requisite rectification and inversion. For example, pulse width modulation may be used to form the AC output of the drive.

STO is the required basic foundation for drive-based functional safety, since it brings a drive safely to a no-torque state. STO is typically used for a prevention of an unexpected startup of machinery or for an emergency stop. Upon activation, STO immediately switches off the drive output to the motor. Motor speed then can coast to a stop.

Certain safety standards govern the safe operation of electrical machinery. One such standard, EN 60204-1, "Safety of machinery. Electrical equipment of machines. General requirements" outlines categories of stopped machinery. STO can be used to meet the stop category 0 of standard EN 60204-1. STO may be paired with other safety functions such that after the enabling the safety function, STO is enabled to ensure that the drive does not restart unexpectedly.

Safety functionally is a built-in feature of electric drives with STO as a standard feature on many drives. Additional safety function can be commissioned with the compact safety functions modules. Certain drives may offer encoderless safety. The function safety of drives may be designed in accordance with EN/IEC 61800-5-2 and comply with the requirements of the European Union Machinery Directive 2006/42/EC.

Generally, STO is used to prevent unexpected startup and enable safe machine maintenance and operation. With the STO feature of a drive activated, the drive will not provide a rotational field at the output supply. This prevents any attached motor from generating torque. The STO function corresponds to an uncontrolled stop in accordance with stop category 0 of EN 60204-1.

Many safety standards and directives govern the operation of electric drives. Manuals such as EN 1037, EN 60204-1, and EN 61800-5-2 contain definitions and regulations pertaining to electric drives and safety standards. Additionally, the EU Machinery Directive 2006/42/EC contains requirements which certain drives must comply with.

Current practice in testing of STO is accomplished with a motor attached to the drive having the STO feature. The STO feature is activated and the test is passed if the motor is not producing any torque when the STO is activated. As such, current testing of an STO feature requires a motor be connected to the drive. This is not desirable when the drive is already installed or in use within a facility. Also, it does not allow for testing the drive independent of a connected load or motor.

### SUMMARY OF THE INVENTION

Safe Torque Off (STO) is a standard safety function in most electric drives. STO is a safety rated circuit in a drive which removes the motor torque by opening the power electronics switches and thus restricting the supply of energy to an attached motor or load. Power electronics switches or power switches may be in the form of IGBTs. Often, after the power electronics switches are opened, the switches are also restricted from operating by the STO feature. As such the proper function of an STO feature may be tested through monitoring of the behavior of power switches of an electric drive.

After an STO feature is activated, the function of that STO feature can be verified by sending switching commands to the power switches of the electric drive. Said switching commands may be sent from, for example a control unit of the electric drive, or from the STO feature itself. If the switches respond to the commands, the feature is not functioning properly. This testing method allows for verification of the STO feature without the need to observe a load or motor connected to the electric drive. As such this method can be employed with or without a motor or load attached to the electric drive. This can be especially useful after a service operation when components of an electric drive or STO circuitry have been replaced.

In an operating state, e.g. where the drive is active and producing an output, a drive is typically connected between an electrical power supply and an AC motor. In order to test the operation of a STO function it is standard practice to enable the STO function and monitor the speed and torque output of the attached motor. Embodiments of the present invention provide the benefit of allowing for the testing of an STO circuit or function without the need for a connected load or motor by monitoring the switching states of power switches of the electric drive in response to switching commands.

Embodiments of the present invention allow for testing of a STO function with an attached load or motor by monitoring output current of an electric drive. When there is no current passing through the output phases of an electric drive to an attached load or motor, the STO function is operating properly. Without an attached load or motor, the STO feature can be verified when there is no output voltage at output phases of an electric drive.

According to an embodiment of the present invention, there is provided a method for testing the function of a Safe Torque Off (STO) feature for an electric drive. The method comprises the steps of first sending an activation signal to the STO feature. After the activation signal is sent, predefined switching commands are transmitted to power switches of the electric drive. Then a switching state of the power switches is determined responsive to the predefined switching commands. Finally, the functionality of the STO feature is determined based at least upon the determined switching states.

According to another embodiment of the present invention, there is provided a Safe Torque Off (STO) module for an electric drive. Said module comprises a STO circuit and logic circuitry. The logic circuitry is configured to test the STO functionality of the STO circuit by sending an activation signal to the STO circuit. Then the logic circuitry sends predefined switching commands to power switches of an electric drive. Then the logic circuitry determines a switching state of the power switches responsive to the predefined switching commands. Finally the logic circuitry determines if the STO circuit is functioning correctly based at least upon the determined switching states.

### BRIEF DESCRIPTION OF THE DRAWINGS

FIGURE 1 illustrates a basic circuit diagram of an electric drive having an STO feature in accordance with at least some embodiments of the present invention.
FIGURE 2 illustrates an example of binary measurement of an output voltage of an electric drive.
FIGURE 3 illustrates a graphical representation of motor speed after enabling an STO function.
FIGURE 4 illustrates an electric drive having an STO module according to certain embodiments of the present invention.

### EMBODIMENTS

### DEFINITIONS

Within the present context the term drive can be any device used to control the supply of electrical energy. Examples of drives which can be used in the present context would include but are not limited to: variable speed drives or converters, variable frequency drives or converters, frequency converters, inverters, adjustable frequency drives or converters, electric drives, and motor drives. As discussed herein, a converter is synonymous with drive.

Within certain embodiments of the present invention, predefined switching commands are sent to the power switches of an electric drive. The switching commands can be such that they instruct the power switches to open or close. The predefined switching commands may come from, for example the same portion of the drive which sends switching commands to the power switches in order to cause modulation and thus an AC output. The predefined switching commands may also come from circuitry associated with an STO feature of the electric drive. The actual switching state of the power switches can then be read, for example from a state feedback signal. As described above, when an STO feature is activated it should prevent the power switches from changing state. As such, if the power switches follow the instructions of the predefined switching commands, the STO-circuit is not working properly because the STO-circuitry in an active state should have prevented the predefined switching commands from causing the power switches to change state.

In some embodiments of the present invention, predefined switching commands are sent to power switches both when the STO feature is activated and when it is deactivated. In these embodiments it is possible to determine both if the STO feature is functioning correctly and if the switching states of the power switches are being read correctly.

Predefined switching commands may be stored in a memory accessible by the STO feature. For example, the STO feature may be implemented on a field-programmable gate array (FPGA) or an integrated circuit (IC). Said FPGA chips have processors capable of executing commands stored in the memory of the FPGA and interfaces for sending signals to device connected to the FPGA. The predefined switching commands may thus be stored in said memory of the FPGA and/or in a further memory accessible to the FPGA. The predefined switching commands may also be sent to the power switches from the FPGA.

Predefined switching commands, as used in certain embodiments of the present invention, can be stored in a memory of the STO feature. For example the memory may be that of an FPGA as outlined above. The predefined switching commands can comprise instructions for power switches of an electric drive associated with the STO feature. These instructions will tell a power switch, preferably a properly working power switch such as an IGBT, to open or close. The predefined switching commands may take the form of short pulses which cause a gate to switch on or off and thus open or close the power switches. The switching commands may also be in the form of a sustained signal. This sustained signal may take the form of, for example, a voltage used for controlling the power switches. The predefined switching commands may be generic or they may be tailored to the specific type of power switches that are involved in the testing. In examples where the predefined switching commands are generic, more than one generic predefined switching command may be sent, either simultaneously or sequentially to insure that a predefined switching command capable of switching an intended power switch is used.

The STO feature may be verified with a motor attached to the electric drive having the STO feature, for example within production testing of STO features. The electric drive may be connected to an electrical source and a motor. The electric drive may then be operated as normal by causing the motor to operate at some normal speed and torque prior to activation and testing of the STO feature. The testing is passed if, after activation of the STO feature, the motor attached to the electric drive is not producing any torque when the STO remains activated.

Embodiments of the present invention allow testing without a motor attached to the electric drive by verifying that the power electronics switches of the electric drive remain open, even when the modulation of the inverter function of the drive is switched on. Therefore, it is not necessary to measure the function of an attached motor to determine if the STO feature is correctly working, for example if it is possible to monitor the power electronics switches themselves.

Certain embodiments of the present invention provide for a method of testing the function of a Safe Torque Off (STO) feature for an electric drive. Said methods comprise some or all of the following steps: sending an activation signal to the STO feature, sending predefined switching commands to power switches of the electric drive, determining a switching state of the power switches in response to the predefined switching commands, and determining if the STO feature is functioning correctly based at least upon the determined switching states. It is preferred that the steps chosen from above are carried out in the order stated, however certain steps can be carried out in another order, and/or with further steps in between, as long as the method otherwise functions in accordance with the present invention.

The STO feature may be determined to be functioning correctly if the power switches are determined to have not changed state in response to the predefined switching commands.

The predefined switching commands can instruct the power switches to connect each output phase of the electric drive first to a positive DC input and then to a negative DC input.

The method of testing may comprise steps for verifying that the switching states of the power switches are being read accurately. Said method comprising the steps of: sending a deactivation signal to the STO feature, sending additional predefined switching commands to the power switches of the electric drive, determining the switching state of the power switches in response to the additional predefined switching commands, and determining if the switching states of the power switches are being read accurately based at least upon the determined switching states. The switching states are determined as being read accurately if the power switches are determined to have changed state in response to the additional predefined switching commands. Testing that the switching states are being determined correctly further serves to ensure that the STO functionality is being determined correctly.

The predefined switching commands can be such that the commands instruct the power switches in groups. The groups may be associated with output phases of the electric drive.

The predefined switching commands may instruct power switches associated with each output phase of the electric drive individually, simultaneously, or sequentially.

Sending an activation signal to the STO feature may be accomplished through the opening of a STO hardware switch. This activation signal may be the disconnection of a voltage or potential which powers a gate driver.

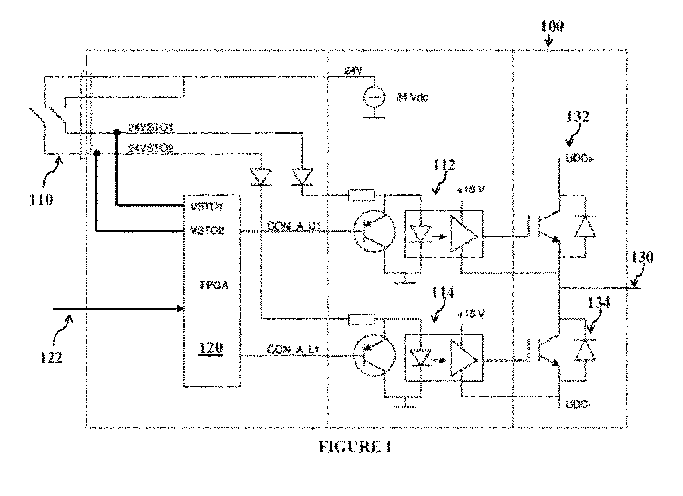

FIGURE 1 illustrates an example STO feature (100) as applied to a phase output of an electric drive (130) in accordance with at least some embodiments of the present invention. Within figure 1, an STO circuit is shown comprising STO switches (110) feeding signals to an FPGA (120), upper switch control circuitry (112) and lower switch control circuitry (114). The upper switch control circuitry (112) is connected to the upper power switch (132) of the illustrated phase and likewise the lower switch control circuitry (114) is connected to the lower power switch (134). Figure 1 is simplified to show only one phase output of the electric drive (130), wherein the electric drive may have a plurality of phase outputs.

As shown in figure 1, opening the STO switches (110) may activate at least a portion of the STO feature (100) and opens the power switches (132 and 134) by shutting down power for gate drivers of the control circuitry (112 and 114). In addition, the status of the STO feature (100) is monitored via the FPGA (120). In some embodiments of the present invention the STO feature (100) may be monitored by other modules of the drive, for instance a central control module. The FPGA (120) may be configured to receive other control inputs (122), for example, a desired modulation or measurements of the drive's performance. If the STO-circuit is opened the drive immediately stops modulating and thus stops inverting the DC supply to an AC supply for use by a motor or load. Within the embodiment illustrated within figure 1, a hardware portion of the STO feature (100) is activated by the physical closing or opening of the STO switches (110).

In certain embodiments of the present invention there is a hardware STO feature and software STO feature. The software STO feature may be configured to cease the modulation signals for DC - AC conversion within the drive in response to certain events. For example, if conditions of an attached motor are monitored and an overspeed condition is detected by the software STO feature the software STO feature may activate and thus stop modulation by ceasing to send the signals which open and close the power switches.

A software STO feature may be incorporated within a FPGA or other control circuitry which is configured to cease modulation without the necessity of opening hardware switches. The software STO feature may also be configured to monitor for conditions related to the electric drive and activate based on those monitored conditions.

In embodiments where both a hardware and software STO feature is available, the software STO feature may respond faster than the hardware STO feature. For this reason in some instances the software STO feature is disabled to allow testing of the hardware STO feature. For example, at the factory production test the software STO feature can be disabled so that the correct operation of the hardware STO feature can be verified. Similarly, the hardware feature may also be disabled in order to test the function of the software STO feature. In the embodiment of figure 1, the STO switches (110) would remain closed in a test of the software STO function.

In some embodiments of the present invention the STO function may have both a software and hardware portion. The software portion of the STO function may be disabled prior to sending the predefined switching commands in order to verify that the hardware portion of the STO is functioning.

Within embodiments having a software STO feature there can be a memory for storing code executable by a processor and connections for sending signals to portions of the STO feature or an attached electric drive as directed by the stored code.

While the FPGA (120) is only connected to one phase output of the electric drive (130) in figure 1, it could be connected to one or more additional phases or all phases of the electric drive so as to control those phases as well.

Certain embodiments of the present invention employ the following testing procedure. During the test, each output phase of the electric drive can be, one by one, switched first to the positive DC busbar. For example, in the system of figure 1, the upper power switch (132) can be turned on and the lower power switch (134) can be turned off. This configuration causes the phase output of the electric drive (130) to be that of the positive DC busbar. Following connection to the positive busbar, the phase output can then connected to the negative busbar. Again as shown in figure 1, the upper power switch (132) can be turned off and the lower power switch (134) turned on. While one phase is being tested in this manner, the other phases can be disabled. In order to disable the output phase, all power switches associated with the phase are turned off. This test may be referred to as a zeros test. During the test, if the STO feature is deactivated, the feedback should follow the reference. In figure 1 this would correspond to the STO switches (110) being closed. Likewise, when the STO switches (110) are opened, the STO feature is activated and the feedback shall not follow the reference.

As outlined above, within certain embodiments of the present invention, each output phase can be testing one by one or individually. Within some embodiments of the present invention the output phases can be tested simultaneously. The output phases may also be tested in groups.

If the above test is run twice, for example once with the STO feature activated and once with it deactivated, it is possible to indicate whether the STO circuitry is correctly operating or not. This indication is possible even without a motor load connected. Indication of the operational status of STO circuitry without a motor load attached eliminates the possibility that the indication is affected by a malfunctioning motor. The STO circuit can be considered faulty if even one of the six power switches follows the reference when performing the zeros test and the STO feature is activated.

Moreover, when the output phases of the electric drive are connected through the stator winding of an attached motor, switching one phase to the positive or the negative DC busbar will make the other two phases appear to be switched likewise. Running the zeroes test as described above, with only one output phase enabled at a time, ensures that the phases being connected through the stator winding does not affect the accuracy of the test.

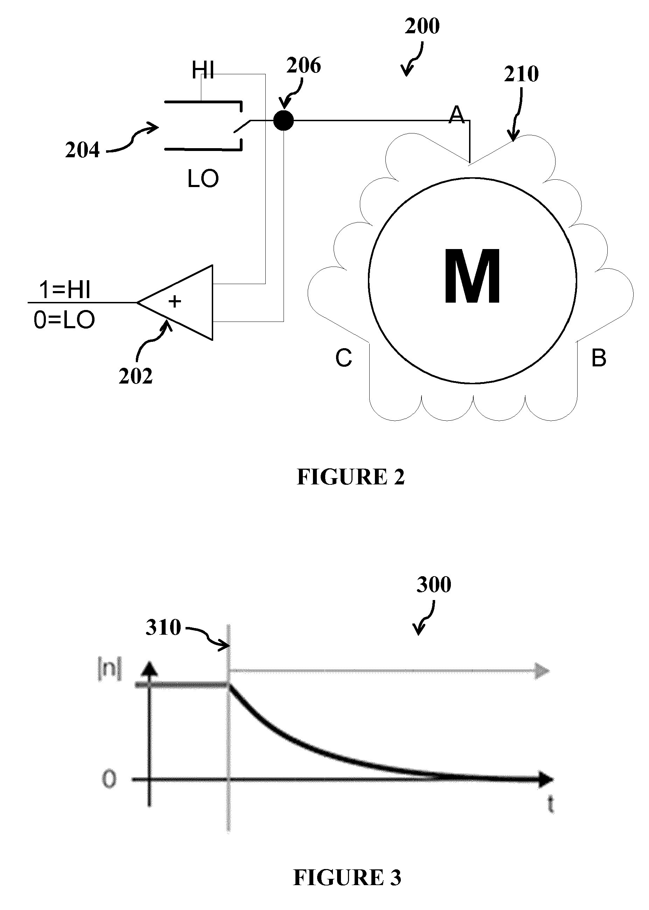

The switching state of the power switches may be determined via a measurement of a voltage at an output phase of the electric drive. For example, a one bit voltage measurement system may be employed as illustrated within figure 2.

FIGURE 2 illustrates a one bit voltage measurement system (200) as employed by certain embodiments of the present invention. Without an attached motor, an electric drive will output substantially no current regardless of STO state. However, voltage can be measured in order to determine switching states of the power switches of the electric drive. Certain drives are equipped with one bit voltage measurement systems (200) at each output phase of the drive. These one bit voltage measurement systems (200) may provide state feedback for various operations of the electric drive. As such, any STO feature testing may also utilize these state feedbacks.

For example, if the state feedback from each phase does not follow the given switch reference, while the STO is activated, it can be stated that the STO is working correctly. At the same time, if the STO is deactivated, the state feedback should follow the given reference. Monitoring the state feedback with the STO deactivated to can eliminate the possibility of faults in the measurement/control circuitry when testing an STO feature.

Within the one bit voltage measurement system (200) of figure 2, there is illustrated a comparator (202) and power switch (204). As can be seen, the power switch (204) switches between a HI and LO signal. The HI and LO signals can be, for example, the positive and negative voltages of the DC supply within the electric drive. The output of the power switch (206) is feed to the comparator (202) and compared to the HI signal of the power switch. In this fashion, if the power switch (204) is connected to the HI signal the comparator will return a 1. If the power switch (204) is connected to a LO signal the comparator will return a 0. The output of the comparator may be feed to control or monitoring circuitry of the electric drive. Also illustrated within figure 2 is an example AC motor (210). As can be seen the one bit voltage measurement system (200) is monitoring one of the phase outputs of the electric drive being fed to phase A of the AC motor (210).

Certain electric drives are equipped with state feedback measurements from all of the output phases. The voltages are measured in the power unit of the electric drive by three 1-bit comparators. The measured comparator data allows for determination of the power switch positions. The comparators follow the status of output voltage lines (for example DC+ or DC-), so when an output voltage line is connected to DC+, the comparators output is 1.

Within certain embodiments of the present invention, the switching state of the power switches can be determined via reading a binary feedback signal from the power switches. This may be done in place of or in addition to a determination of a voltage or current measurement at an output phase of the drive.

FIGURE 3 illustrates a graph of motor speed [n] (300) as a function of time before and after an STO feature is activated. Within the graph, a motor is spinning at some speed [n] prior to the time that an STO feature is activated (310). After the STO feature is activated, the motor speed falls to zero as no torque is being produced by the motor.

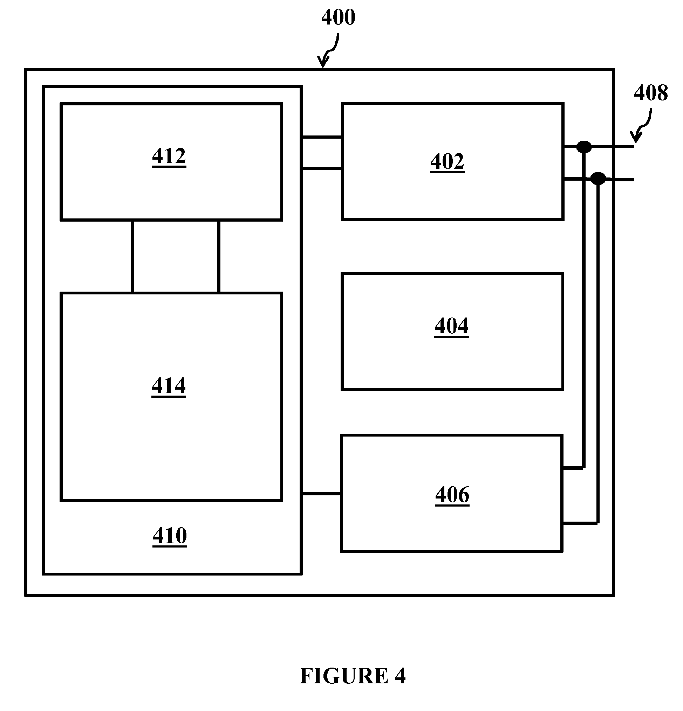

FIGURE 4 illustrates an electric drive (400) having an STO module (410) according to an embodiment of the present invention. The STO module (410) comprises: a safe torque off (STO) circuit (412) and logic circuitry (414). The logic circuitry (414) is configured to test the STO functionality of the STO circuit by: sending an activation signal to the STO circuit (412), sending predefined switching commands to power switches (402) of the electric drive (400), determining a switching state of the power switches (402) in response to the predefined switching commands, and determining if the STO circuit (412) is functioning correctly based at least upon the determined switching states.

The logic circuitry (414) can be an FPGA as previously illustrated. The logic circuitry may also be a memory and processor configured to execute stored commands.

Within certain embodiments of the present invention, the logic circuitry (414) may be further configured such that the STO circuit (412) is determined to be functioning correctly if the power switches (402) are determined to not change state in response to the predefined switching commands. The predefined switching commands can instruct the power switches (402) to connect each output phase of the electric drive first to a positive DC input and then to a negative DC input. The DC input may be from a DC supply (404) of the electric drive (400).

The logic circuitry may be further configured to verify that the switching states of the power switches (402) are being read accurately. This can be verified by; sending a deactivation signal to the STO circuit (412), sending additional predefined switching commands to the power switches (402) of the electric drive (400), determining the switching state of the power switches (402) in response to the additional predefined switching commands, and determining if the switching states of the power switches (402) are being read accurately based at least upon the determined switching states. The switching states are determined as being read accurately if the power switches (402) are determined to have changed state in response to the additional predefined switching commands.

The switching state of the power switches (402) may be determined via measurement circuitry (406) configured to measure a voltage at an output phase (408) of the electric drive (400).

The logic circuitry (414) may be further configured to disable a software portion of the STO module (410) prior to sending the predefined switching commands in order to verify that the hardware portion of the STO circuit (412) is functioning.

The switching state of the power switches (402) may be determined via measurement circuitry (406) configured to compare the voltage at an output of the power switches (402) and return a binary feedback signal.

The predefined switching commands may be such that the commands instruct the power switches (402) in groups associated with output phases of the electric drive.

The predefined switching commands can instruct power switches (402) associated with each output phase of the electric drive individually.

The components of figure 4 are illustrated as being connected. The number and length of the lines connecting the components is not indicative of the type or amount of signal or power transfer along those lines.

The STO module (410) as described above may be incorporated into an electric drive (400) as shown in figure 4.

As discussed herein, the STO feature can be considered to be active or activated when the STO is configured to prevent an attached motor from producing torque. It should be understood that the STO could be considered to be in an active state when it is configured to allow an attached motor to produce torque. The teachings of the specification are the same regardless of which state of the STO feature is considered active.

It is to be understood that the embodiments of the invention disclosed are not limited to the particular structures, process steps, or materials disclosed herein, but are extended to equivalents thereof as would be recognized by those ordinarily skilled in the relevant arts. It should also be understood that terminology employed herein is used for the purpose of describing particular embodiments only and is not intended to be limiting.

Reference throughout this specification to one embodiment or an embodiment means that a particular feature, structure, or characteristic described in connection with the embodiment is included in at least one embodiment of the present invention. Thus, appearances of the phrases "in one embodiment" or "in an embodiment" in various places throughout this specification are not necessarily all referring to the same embodiment. Where reference is made to a numerical value using a term such as, for example, about or substantially, the exact numerical value is also disclosed.

As used herein, a plurality of items, structural elements, compositional elements, and/or materials may be presented in a common list for convenience. However, these lists should be construed as though each member of the list is individually identified as a separate and unique member. Thus, no individual member of such list should be construed as a de facto equivalent of any other member of the same list solely based on their presentation in a common group without indications to the contrary. In addition, various embodiments and example of the present invention may be referred to herein along with alternatives for the various components thereof. It is understood that such embodiments, examples, and alternatives are not to be construed as de facto equivalents of one another, but are to be considered as separate and autonomous representations of the present invention.

Furthermore, the described features, structures, or characteristics may be combined in any suitable manner in one or more embodiments. In the following description, numerous specific details are provided, such as examples of lengths, widths, shapes, etc., to provide a thorough understanding of embodiments of the invention. One skilled in the relevant art will recognize, however, that the invention can be practiced without one or more of the specific details, or with other methods, components, materials, etc. In other instances, well-known structures, materials, or operations are not shown or described in detail to avoid obscuring aspects of the invention.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

The verbs "to comprise" and "to include" are used in this document as open limitations that neither exclude nor require the existence of also un-recited features. The features recited in depending claims are mutually freely combinable unless otherwise explicitly stated. Furthermore, it is to be understood that the use of "a" or "an", that is, a singular form, throughout this document does not exclude a plurality.

### ACRONYMS LIST

- AC: Alternating Current
- DC: Direct Current
- FPGA: Field-Programmable Gate Array
- IC: Integrated Circuit
- IGBT: Insulated Gate Bipolar Transistor
- STO: Safe Torque Off

**REFERENCE SIGNS LIST**

| | |
|---|---|
| 100 | STO Feature |
| 110 | STO Switches |
| 112 | Upper Switch Control Circuitry |
| 114 | Lower Switch Control Circuitry |
| 120 | FPGA |
| 122 | Control Inputs |
| 130 | Phase Output of an Electric Drive |
| 132 | Upper Power Switch |
| 134 | Lower Power Switch |
| 200 | One Bit Voltage Measurement System |
| 202 | Comparator |
| 204 | Power Switch |
| 206 | Output of the Power Switch |
| 210 | AC Motor |
| 300 | Graph of Motor Speed |
| 310 | Request to Activate an STO Feature |
| 400 | Electric Drive |
| 402 | Power Switches |
| 404 | DC Supply |
| 406 | Measurement Circuitry |
| 408 | Output Phase of the Electric Drive |
| 410 | STO Module |
| 412 | STO Circuit |
| 414 | Logic Circuitry |

## Claims

1. A method for testing the function of a Safe Torque Off (STO) feature for an electric drive comprising the steps of:
- sending an activation signal to the STO feature,
- sending predefined switching commands to power switches of the electric drive,
- determining a switching state of the power switches in response to the predefined switching commands, and
- determining if the STO feature is functioning correctly based at least upon the determined switching states.

2. The method of claim 1 wherein the STO feature is determined to be functioning correctly if the power switches are determined to have not changed state in response to the predefined switching commands.

3. The method according to any proceeding claim wherein the predefined switching commands instruct the power switches to connect each output phase of the electric drive first to a positive DC input and then to a negative DC input.

4. The method according to any preceding claim further comprising steps for verifying that the switching states of the power switches are being read accurately by:
- sending a deactivation signal to the STO feature,
- sending additional predefined switching commands to the power switches of the electric drive,
- determining the switching state of the power switches in response to the additional predefined switching commands, and
- determining if the switching states of the power switches are being read accurately based at least upon the determined switching states,
wherein the switching states are determined as being read accurately if the power switches are determined to have changed state in response to the additional predefined switching commands.

5. The method according to any preceding claim further comprising the step of disabling a software portion of the STO function prior to sending the predefined switching commands in order to verify that the hardware portion of the STO is functioning.

6. A Safe Torque Off (STO) module for an electric drive comprising:
- a safe torque off (STO) circuit,
- logic circuitry configured to test the STO functionality of the STO circuit by:
o sending an activation signal to the STO circuit,
o sending predefined switching commands to power switches of the electric drive,
o determining a switching state of the power switches in response to the predefined switching commands, and
o determining if the STO circuit is functioning correctly based at least upon the determined switching states.

7. The STO module of claim 6 wherein the logic circuitry is further configured such that the STO circuit is determined to be functioning correctly if the power switches are determined to not change state in response to the predefined switching commands.

8. The STO module of claims 6 or 7 wherein the predefined switching commands instruct the power switches to connect each output phase of the electric drive first to a positive DC input and then to a negative DC input.

9. The STO module of any of claims 6 - 8 wherein the logic circuitry is further configured to verify that the switching states of the power switches are being read accurately by;
- sending a deactivation signal to the STO circuit,
- sending additional predefined switching commands to the power switches of the electric drive,
- determining the switching state of the power switches in response to the additional predefined switching commands, and
- determining if the switching states of the power switches are being read accurately based at least upon the determined switching states,
wherein the switching states are determined as being read accurately if the power switches are determined to have changed state in response to the additional predefined switching commands

10. The STO module of any of claims 6 - 9 wherein the switching state of the power switches is determined via measurement circuitry configured to measure a voltage at an output phase of the electric drive.

11. The STO module of any of claims 6 - 10 wherein the logic circuitry is further configured to disable a software portion of the STO module prior to sending the predefined switching commands in order to verify that the hardware portion of the STO circuit is functioning.

12. The STO module of any of claims 6 - 11 wherein the switching state of the power switches is determined via measurement circuitry configured to compare the voltage at an output of the power switches and return a binary feedback signal.

13. The STO module of any of claims 6 - 12 wherein the predefined switching commands are such that the commands instruct the power switches in groups associated with output phases of the electric drive.

14. The STO module of any of claims 6 - 13 wherein the predefined switching commands instruct power switches associated with each output phase of the electric drive individually.

15. An electric drive comprising the STO module of any of claims 6 - 14.
